# EUROPEAN PATENT SPECIFICATION

(11) **EP 1 874 524 B1**
(45) Date of publication and mention of the grant of the patent: **11.03.2009**
(21) Application number: 06737184.9
(22) Date of filing: 06.03.2006
(51) Int. Cl.: B29C 59/04, B29C 39/14, G03F 7/00

(54) **APPARATUS AND METHOD FOR MAKING MICROREPLICATED ARTICLE**
VORRICHTUNG UND VERFAHREN ZUR HERSTELLUNG EINES MIKROREPLIZIERTEN ARTIKELS
APPAREIL ET PROCEDE DE FABRICATION D'UN ARTICLE MICROREPRODUIT

(30) Priority: 09.03.2005 US 661426 P
(43) Date of publication of application: 09.01.2008
(73) Proprietor: 3M Innovative Properties Company, St. Paul MN 55133-3427 (US)
(72) Inventor: STRAND, John T., 3M Center, Saint Paul, Minnesota 55133-3427 (US); WETZELS, Serge, Saint Paul, Minnesota 55133-3427 (US)
(74) Representative: Vossius & Partner
(86) International application number: PCT/US2006/007976
(87) International publication number: WO 2006/098939

(56) References cited:
- EP-A- 0 896 259
- US-A- 3 893 795
- US-A- 4 280 978
- US-A- 5 330 799
- US-B1- 6 358 030

## Description

### Field

The disclosure relates generally to the continuous casting of material onto a web, and more specifically to the casting of articles having a high degree of registration between patterns cast on opposite sides of the web.

### Background

In fabricating many articles, from printing newspapers to fabricating sophisticated electronic and optical devices, it is necessary to apply some material that is at least temporarily in liquid form to opposite sides of a substrate. Such processes and devices are exemplary disclosed in EP 0 896 259 A2, US 4,280,978 and US 5,330,799. In many cases, the material is applied to the substrate in a predetermined pattern; in the case of e.g. printing, ink is applied in the pattern of letters and pictures. It is common in such cases for there to be at least a minimum requirement for registration between the patterns on opposite sides of the substrate.

When the substrate is a discrete article such as a circuit board, the applicators of a pattern may usually rely on an edge to assist in achieving registration. But when the substrate is a web and it is not possible to rely on an edge of the substrate in maintaining registration, the problem becomes a bit more difficult. Still, even in the case of webs, when the requirement for registration is not severe, e.g. a drift out of perfect registration of greater than 100 micrometers is tolerable, mechanical expedients are known for controlling the material application to that extent. The printing art is replete with devices capable of meeting such a standard.

However, in some products having patterns on opposite sides of a substrate, a much more accurate registration between the patterns is required. In such a case, if the web is not in continuous motion, apparatuses are known that can apply material to such a standard. And if the web is in continuous motion, if it is tolerable, as in e.g. some types of flexible circuitry, to reset the patterning rolls to within 100 micrometers, or even 5 micrometers, of perfect registration once per revolution of the patterning rolls, the art still gives guidelines about how to proceed.

However, in e.g. optical articles such as brightness enhancement films, it is required for the patterns in the optically transparent polymer applied to opposite sides of a substrate to be out of registration by no more than a very small tolerance at any point in the tool rotation. Thus far, the art is silent about how to cast a patterned surface on opposite sides of a web that is in continuous motion so that the patterns are kept continuously, rather than intermittently, in registration within 100 micrometers.

### Summary

One aspect of the present disclosure involves a roll to roll microreplication apparatus. This apparatus includes a first patterned roll having a first diameter and a second patterned roll having a second diameter. A drive assembly is included and is configured to rotate the first patterned roll and the second patterned roll such that the first and second rolls maintain a continuous registration within about 100 micrometers. The drive assembly may include a single motor assembly, or first and second motor assemblies devoted to the first and second patterned rolls, respectively. The second diameter is about 0.01 to about 1 percent larger than the first diameter.

Another aspect of the present disclosure involves a method of making a microreplicated article including a web having first and second opposed surfaces. A first patterned roll and a second patterned roll are counter-rotated at an equal rotational speed but a non-equal surface speed. The web is passed between the first patterned roll and the second patterned roll. A first liquid is disposed on the web first surface, and is contacted by the first patterned roll. A second liquid is disposed on the web second surface, and is contacted by the second patterned roll.

The first patterned roll and the second patterned roll maintain a constant registration of less than about 100 micrometers. In some instances, the first and second microreplicated rolls maintain a constant registration of less than about 75 micrometers, or to less than about 50 micrometers, or less than about 10 micrometers.

### Definitions

In the context of this disclosure, "registration," means the positioning of structures on one surface of the web in a defined relationship to other structures on the opposite side of the same web.

In the context of this disclosure, "web" means a sheet of material having a fixed dimension in one direction and either a predetermined or indeterminate length in the orthogonal direction.

In the context of this disclosure, "continuous registration," means that at all times during rotation of first and second patterned rolls the degree of registration between structures on the rolls is better than a specified limit.

In the context of this disclosure, "microreplicated" or "microreplication" means the production of a microstructured surface through a process where the structured surface features retain an individual feature fidelity during manufacture, from product-to-product, that varies no more than about 100 micrometers.

### Brief Description of the Drawings

In the several figures of the attached drawing, like parts bear like reference numerals, and:
**FIG. 1** illustrates a perspective view of an example embodiment of a system including a system according to the present disclosure;
**FIG. 2** illustrates a close-up view of a portion of the system of **FIG. 1** according to the present disclosure;
**FIG. 3** illustrates another perspective view of the system of **FIG.1** according to the present disclosure;
**FIG. 4** illustrates a schematic view of an example embodiment of a casting apparatus according to the present disclosure;
**FIG. 5** illustrates a close-up view of a section of the casting apparatus of **FIG. 4** according to the present disclosure;
**FIG. 6** illustrates a schematic view of an example embodiment of a roll mounting arrangement according to the present disclosure;
**FIG. 7** illustrates a schematic view of an example embodiment of a mounting arrangement for a pair of patterned rolls according to the present disclosure;
**FIG. 8** illustrates a schematic view of an example embodiment of a motor and roll arrangement according to the present disclosure;
**FIG. 9** illustrates a schematic view of an example embodiment of a means for controlling the registration between rolls according to the present disclosure;
**FIG. 10** illustrates a block diagram of an example embodiment of a method and apparatus for controlling registration according to the present disclosure; and
**FIG.11** illustrates a cross-sectional view of an illustrative article made according to the present disclosure.

### Detailed Description

Generally, the disclosure of the present disclosure is directed to a flexible substrate coated with microreplicated patterned structures on each side. The microreplicated articles are registered with respect to one another to a high degree of precision. The structures on opposing sides can cooperate to give the article optical qualities as desired, in some embodiments, the structures are a plurality of lens features.

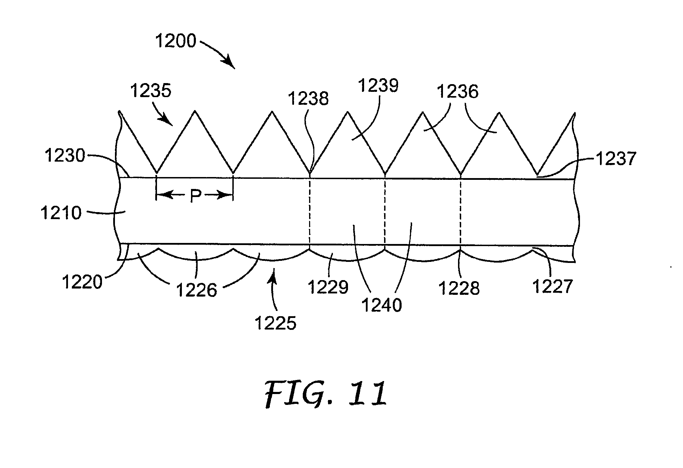

Referring to **FIG. 11****,** illustrated is an example embodiment of a two-sided microreplicated article **1200.** The article **1200** includes a web **1210** having opposed first and second surfaces **1220, 1230.** First and second surfaces **1220, 1230** include first and second microreplicated structures **1225, 1235,** respectively. First microreplicated structure **1225** includes a plurality of features **1226,** which in the embodiment shown are cylindrical lenses with an effective diameter of about 142 micrometers. Second microreplicated structure **1235** includes a plurality of saw-tooth or pyramidal prismatic features **1236.** It is understood that the opposed first and second microreplicated structures **1225, 1235** can be any useful form and/or shape other than the particular shapes illustrated in **FIG. 11****.**

In the example embodiment shown, first and second features **1226, 1236** have the same pitch or period of repetition **P,** e.g., the period of the first feature is from 10 to 500 micrometers, from 50 to 250 micrometers or about 150 micrometers, and the period of repetition of the second feature is the same. The ratio of the period of the first and second features can be a whole number ratio (or the inverse), though other combinations are permissible.

In the example embodiment shown, opposed microreplicated features **1226, 1236** cooperate to form a plurality of lens features **1240.** In the example embodiment shown, the lens features **1240** are lenticular lenses. Since the performance of each lens feature **1240** is a function of the alignment of the opposed features **1229,1239** forming each lens, precision alignment or registration of the lens features is preferable.

Optionally, the article **1200** also includes first and second land areas **1227, 1237.** The land area is defined as the material between the substrate surfaces **1220, 1230** and the bottom of each respective feature, i.e., valleys **1228, 1238.** The first land area **1228** can be at least about 10 micrometers on the lens side and the second land area **1238** can be about at least about 25 micrometers on the prism side. The land area can assist in the features having good adherence to the web **1210** and can also aid in replication fidelity. The land area positioning may also be used to coordinate features on first and second sides of the web **1210,** as desired.

The article **1200** described above can be made using an apparatus and method for producing precisely aligned microreplicated structures on opposed surfaces of the web, the apparatus and methods which are described in detail below.

The first microreplicated structure can be made on a first patterned roll by casting and curing a curable liquid onto the first side of the web. The first curable liquid can be a photocurable acrylate resin solution including photomer 6010, available from Cognis Corp., Cincinnati, Ohio; SR385 tetrahydrofurfuryl acrylate and SR238 (70/15/15 %) 1,6-hexanediol diacrylate, both available from Satomer Co., Expon, Pennsylvania; Camphorquinone, available from Hanford Research Inc., Stratford, Connecticut; and Ethyl-4-dimethylamino Benzoate (0.75/0.5 %), available from Aldrich Chemical Co., Milwaukee, Wisconsin.

The second microreplicated structure can be made on a second patterned roll by casting and curing a curable liquid onto the second side of the web. The second curable liquid can be the same or different as the first curable liquid. In some embodiments, the first and second curable liquid is disposed on the web surface prior to passing through the first and second patterned roll, respectively. In other embodiments, the first curable liquid is disposed on the first patterned roll and the second curable liquid is disposed on the second patterned roll, which is then transferred to the web from the patterned rolls.

After each respective structure is cast into a pattern, each respective pattern is externally cured using a radiation source that is tuned to the photoinitator within each curable liquid. An ultraviolet light source may be applicable in some situations. A peel roll may then be used to remove the microreplicated article from the second patterned roll. Optionally, a release agent or coating can be used to assist removal of the patterned structures from the patterned tools.

Illustrative process settings used to create the article described above are as follows. A web speed of about 0.3 meter (1 foot) per minute with a web tension into and out of casting apparatus of about 8 Newtons (2 pounds force). A peel roll draw ratio of about 5% was used to pull the web off the second patterned tool. A nip pressure of about 16 Newtons (4 pounds force) was used. There was a gap between the first and second patterned rolls of about 0.025 centimeters (0.01 inches). Resin can be supplied to the first surface of the web using a dropper coating apparatus and resin can be supplied to the second surface at a rate of about 1.35 ml/min, using a syringe pump.

The first patterned roll included a series of negative images for forming cylindrical lenses with a 142 micrometer diameter at 150 micrometer pitch. The second patterned roll included a series of negative images for forming a plurality of symmetric prisms with 60 degree included angle at 150 micrometer pitch.

Generally, the article described above may be made by a system and method, disclosed hereinafter, for producing two-sided microreplicated structures with registration of better than about 100 micrometers, or better than 50 micrometers, or less than 25 micrometers, or less than 10 micrometers, or less than 5 micrometers. The system generally includes a first patterning assembly and a second patterning assembly. Each respective assembly creates a microreplicated pattern on a respective surface of a web having a first and a second surface. A first pattern is created on the first side of the web and a second pattern is created on the second surface of the web.

Each patterning assembly includes means for applying a coating, a patterning member, and a curing member. Typically, patterning assemblies include patterned rolls and a support structure for holding and driving each roll. Coating means of the first patterning assembly dispenses a first curable coating material on a first surface of the web. Coating means of the second patterning assembly dispenses a second curable coating material on a second surface of the web, wherein the second surface is opposite the first surface. Typically, first and second coating materials are of the same composition.

After the first coating material is placed on the web, the web passes over a first patterned member, wherein a pattern is created in the first coating material. The first coating material is then cured to form the first pattern. Subsequently, after the second coating material is placed on the web, the web passes over a second patterned member, wherein a pattern is created in the second coating material. The second coating material is then cured to form the second pattern. Typically, each patterned member is a microreplicated tool and each tool typically has a dedicated curing member for curing the material. However, it is possible to have a single curing member that cures both first and second patterned materials. Also, it is possible to place the coatings on the patterned tools.

The system also includes means for rotating the first and second patterned rolls such that their patterns are transferred to opposite sides of the web while it is in continuous motion, and said patterns are maintained in continuous registration on said opposite sides of the web to better than about 100 micrometers or better than 10 micrometers.

An advantage of the present disclosure is that a web having a microreplicated structure on each opposing surface of the web can be manufactured by having the microreplicated structure on each side of the web continuously formed while keeping the microreplicated structures on the opposing sides registered generally to within 100 micrometers of each other, or within 50 micrometers, or within 20 micrometers, or within 10 micrometers, or within 5 micrometers.

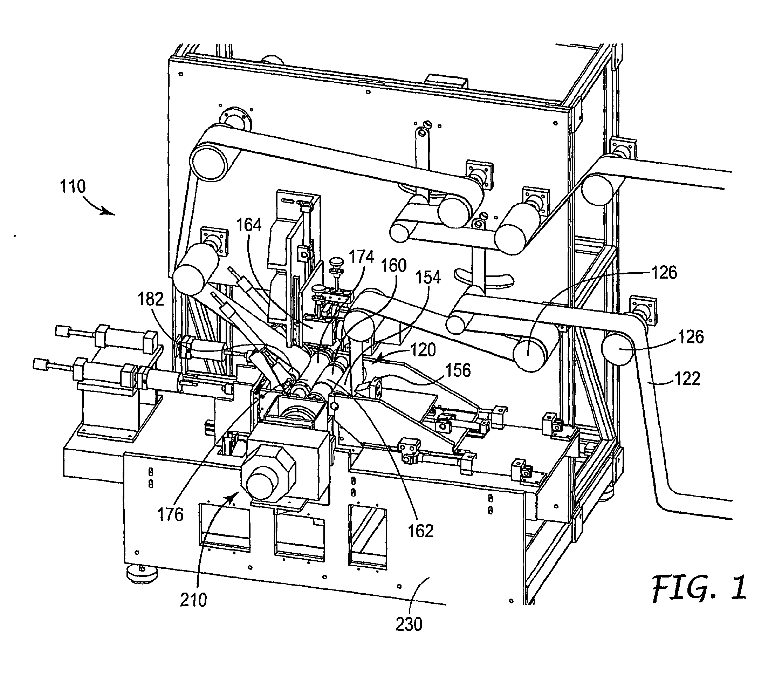

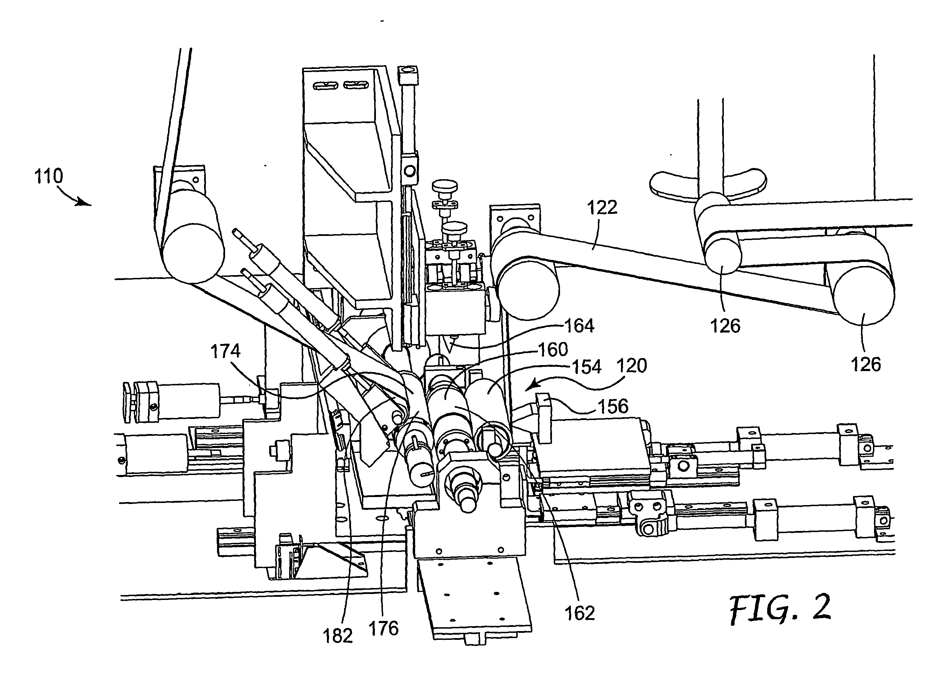

Referring now to **FIGS. 1-2****,** an example embodiment of a system **110** including a roll to roll casting apparatus **120** is illustrated. In the depicted casting apparatus **120,** a web **122** is provided to the casting apparatus **120** from a main unwind spool (not shown). The exact nature of web **122** can vary widely, depending on the product being produced, as described above. However, when the casting apparatus **120** is used for the fabrication of optical articles it is usually convenient for the web **122** to be translucent or transparent, to allow curing through the web **122.** The web **122** is directed around various rollers **126** into the casting apparatus **120.**

Accurate tension control of the web **122** is beneficial in achieving optimal results, so the web **122** may be directed over a tension-sensing device (not shown). In situations where it is desirable to use a liner web to protect the web **122,** the liner web is typically separated at the unwind spool and directed onto a liner web wind-up spool (not shown). The web **122** can be directed via an idler roll to a dancer roller for precision tension control. Idler rollers can direct the web **122** to a position between nip roller **154** and first coating head **156.**

A variety of coating methods may be employed. In the illustrated embodiment, first coating head **156** is a die coating head. The web **122** then passes between the nip roll **154** and first patterned roll **160.** The first patterned roll **160** has a patterned surface **162,** and when the web **122** passes between the nip roller **154** and the first patterned roll **160** the material dispensed onto the web **122** by the first coating head **156** is shaped into a negative of patterned surface **162.**

While the web **122** is in contact with the first patterned roll **160,** material is dispensed from second coating head **164** onto the other surface of web **122.** In parallel with the discussion above with respect to the first coating head **156,** the second coating head **164** is also a die coating arrangement including a second extruder (not shown) and a second coating die (not shown). In some embodiments, the material dispensed by the first coating head **156** is a composition including a polymer precursor and intended to be cured to solid polymer with the application of curing energy such as, for example, ultraviolet radiation.

Material that has been dispensed onto web **122** by the second coating head **164** is then brought into contact with second patterned roll **174** with a second patterned surface **176.** In parallel with the discussion above, in some embodiments, the material dispensed by the second coating head **164** is a composition including a polymer precursor and intended to be cured to solid polymer with the application of curing energy such as, for example, ultraviolet radiation.

At this point, the web **122** has had a pattern applied to both sides. A peel roll **182** may be present to assist in removal of the web **122** from second patterned roll **174.** In some instances, the web tension into and out of the roll to roll casting apparatus is nearly constant.

The web **122** having a two-sided microreplicated pattern is then directed to a wind-up spool (not shown) via various idler rolls. If an interleave film is desired to protect web **122,** it may be provided from a secondary unwind spool (not shown) and the web and interleave film are wound together on the wind-up spool at an appropriate tension.

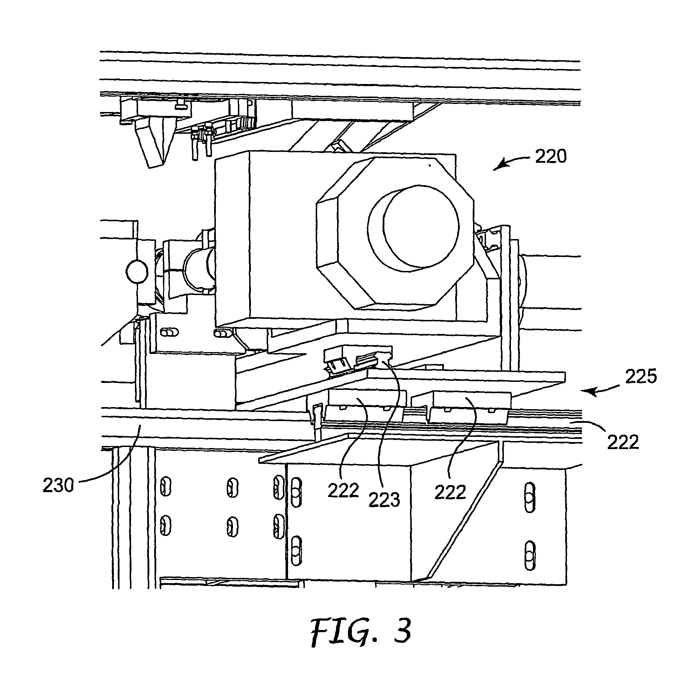

Referring to **FIGS. 1-3****,** first and second patterned rolls are coupled to first and second motor assemblies **210, 220,** respectively. Support for the motor assemblies **210, 220** is accomplished by mounting assemblies to a frame **230,** either directly or indirectly. The motor assemblies **210, 220** are coupled to the frame using precision mounting arrangements. In the example embodiment shown, first motor assembly **210** is fixedly mounted to frame **230.** Second motor assembly **220,** which is placed into position when web **122** is threaded through the casting apparatus **120,** may need to be positioned repeatedly and is therefore movable, both in the cross- and machine direction. Movable motor arrangement **220** may be coupled to linear slides **222** to assist in repeated accurate positioning, for example, when switching between patterns on the rolls. Second motor arrangement **220** also includes a second mounting arrangement **225** on the backside of the frame **230** for positioning the second patterned roll **174** side-to-side relative to the first patterned roll **160.** In some cases, second mounting arrangement **225** includes linear slides **223** allowing accurate positioning in the cross machine directions.

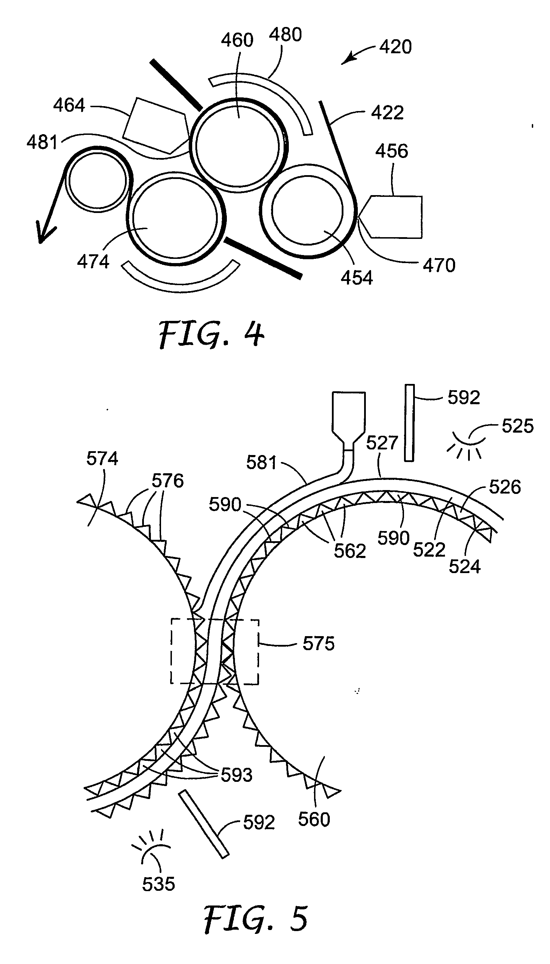

Referring to **FIG. 4****,** an example embodiment of a casting apparatus **420** for producing a two-sided web **422** with registered microreplicated structures on opposing surfaces is illustrated. Assembly includes first and second coating means **456, 464,** a nip roller **454,** and first and second patterned rolls **460, 474.** Web **422** is presented to the first coating means **456,** in this example a first extrusion die **456.** First die **456** dispenses a first curable liquid layer coating **470** onto the web **422.** First coating **470** is pressed into the first patterned roller **460** by means of a nip roller **454,** typically a rubber covered roller. While on the first patterned roll **460,** the coating is cured using a curing source **480,** for example, a lamp, of suitable wavelength light, such as, for example, an ultraviolet light source.

A second curable liquid layer **481** is coated on the opposite side of the web **422** using a second side extrusion die **464.** The second layer **481** is pressed into the second patterned tool roller **474** and the curing process repeated for the second coating layer **481.** Registration of the two coating patterns is achieved by maintaining the tool rollers **460, 474** in a precise angular relationship with one another, as will be described hereinafter.

Referring to **FIG. 5****,** a close-up view of a portion of first and second patterned rolls **560, 574** is illustrated. First patterned roll **560** has a first pattern **562** for forming a microreplicated surface. Second pattern roll **574** has a second microreplicated pattern **576.** In the example embodiment shown, first and second patterns **562, 576** are the same pattern, though the patterns may be different. In the illustrated embodiment, the first pattern **562** and the second pattern **576** are shown as prism structures, however, any single or multiple useful structures can form one or both of the first pattern **562** and the second pattern **576.**

As a web **522** passes over the first roll **560,** a first curable liquid (not shown) on a first surface **524** is cured by a curing light source **525** near a first region **526** on the first patterned roll **560.** A first microreplicated patterned structure **590** is formed on the first side **524** of the web **522** as the liquid is cured. The first patterned structure **590** is a negative of the pattern **562** on the first patterned roll **560.** After the first patterned structure **590** is formed, a second curable liquid **581** is dispensed onto a second surface **527** of the web **522.** To insure that the second liquid **581** is not cured prematurely, the second liquid **581** can be isolated from the first curing light **525,** by a locating the first curing light **525** so that it does not fall on the second liquid **581.** Alternatively, shielding means **592** can be placed between the first curing light **525** and the second liquid **581.** Also, the curing sources can be located inside their respective patterned rolls where it is impractical or difficult to cure through the web.

After the first patterned structure **590** is formed, the web **522** continues along the first roll **560** until it enters the gap region **575** between the first and second patterned rolls **560, 574.** The second liquid **581** then engages the second pattern **576** on the second patterned roll and is shaped into a second microreplicated structure, which is then cured by a second curing light **535.** As the web **522** passes into the gap **575** between first and second patterned rolls **560, 574,** the first patterned structured **590,** which is by this time substantially cured and bonded to the web **522,** restrains the web **522** from slipping while the web **522** begins moving into the gap **575** and around the second patterned roller **574.** This removes web stretching and slippages as a source of registration error between the first and second patterned structures formed on the web.

By supporting the web **522** on the first patterned roll **560** while the second liquid **581** comes into contact with the second patterned roll **574,** the degree of registration between the first and second microreplicated structures **590, 593** formed on opposite sides **524, 527** of the web **522** becomes a function of controlling the positional relationship between the surfaces of the first and second patterned rolls **560, 574.** The S-wrap of the web around the first and second patterned rolls **560, 574** and between the gap 575 formed by the rolls minimizes effects of tension, web strain changes, temperature, microslip caused by mechanics of nipping a web, and lateral position control. Typically, the S-wrap maintains the web **522** in contact with each roll over a wrap angle of 180 degrees, though the wrap angle can be more or less depending on the particular requirements.

It is within the skill and knowledge of one having ordinary skill in the art to select the proper roll for any particular application. In particular applications, it may be useful to create a uniform tension zone between the two microreplication tools, such as the first patterned roll **560** and the second patterned roll **574.** By creating a uniform tension zone, a uniform peel angle from the first microreplication tool and a controllable, more uniform coating thickness from the second microreplication tool may be achieved. This can translate into caliper specifications and tolerances as dictated by product requirements. In some cases, a uniform peel angle may create a more optically uniform product.

In some cases, the first microreplicated tool and the second microreplicated tool rotate in opposite directions. A web is coated with a UV curable resin. It will be appreciated that a first rolling bank may occur between the first microreplicated tool and a rubber nip roller. A second rolling bank may occur between the first microreplicated tool and the second microreplicated tool, immediately after the point at which the web is peeled from the first microreplicated tool. The amount of force applied to drive the rubber nip roller into the first microreplicated tool is one of the variables that controls the amount of resin between the web and the first microreplicated tool.

One way of producing coatings on a moving web is through the use of a coating bead or rolling bank, in which the web passes through a nip created by two rolls. At the nip point is a rolling bank of coating material that is continually replenished. As the web passes through the nip, a small and evenly distributed amount of coating is deposited on the web. As the web moves, mechanical forces cause the coating to "roll" in the nip, hence the term "rolling bank".

One way to address this issue is by creating a second microreplicated tool that has a diameter that is slightly larger than the diameter of the first microreplicated tool. In the present invention , the second microreplicated tool may have a diameter that is about 0.01 to about 1 percent larger than a diameter of the first microreplicated tool.

By rotating the first and second microreplicated tools at exactly the same rotational speed, the small percentage larger diameter of the second microreplicated tool results in the second microreplicated tool having a slightly higher surface rotational speed than the first microreplicated tool. This results in a slightly higher tension zone, thus reducing or even eliminating the pouch that may otherwise form. To maintain alignment of cross tool features, which turn into down web features, the second microreplicated tool is diamond turned with all cross tool features at exactly the same rotational angle as the feature on the first microreplicated tool.

An advantage of this embodiment is that a draw zone is created between the two microreplicated tools. Draw zones can be used to create a uniform tension zone when peeling material from a microreplicated tool. The uniform tension will reduce or eliminate the difference in web span between the two tools created by the dynamics of the pouch.

As the cross web width of the pattern increases, the amount of tension required to achieve a uniform peel angle increases. Patterns with higher features also require higher tensions to achieve a uniform peel. Peel angle is also important for creating an optically uniform material. When peeled at different angles from a microreplicated tool, different areas experience different bending. This differential bending results is small optical nonuniformities on the product. By eliminating the dynamic flutter created by the pouch, a more uniform peel will be achieved. This will result in better alignment, more uniform land and a more uniform optical appearance and performance.

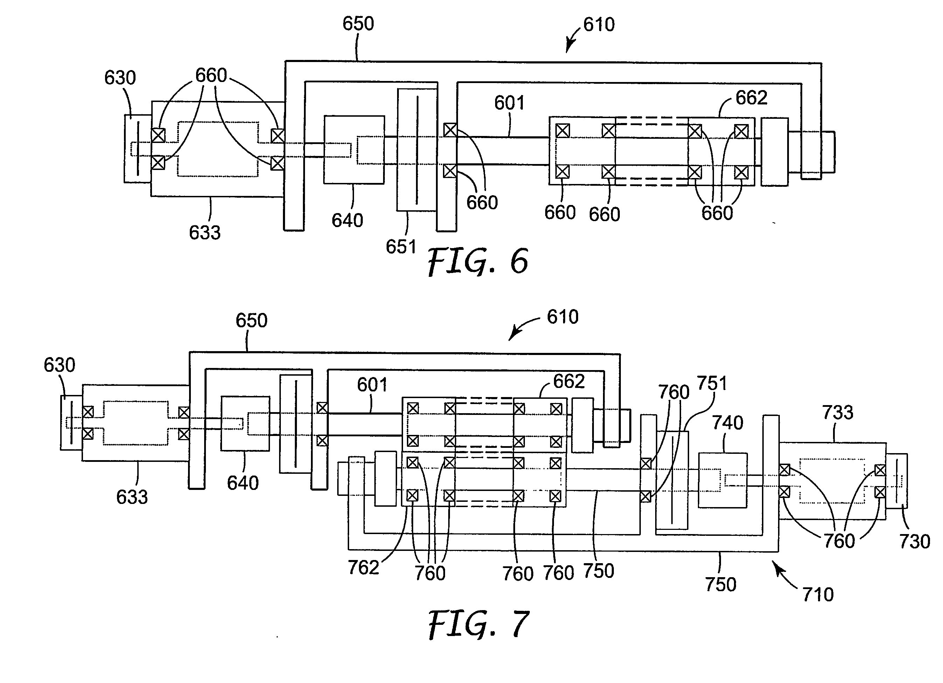

Referring to **FIG. 6****,** a motor mounting arrangement is illustrated. A motor **633** for driving a tool or patterned roll **662** is mounted to the machine frame **650** and connected through a coupling **640** to a rotating shaft **601** of the patterned roller **662.** The motor **633** is coupled to a primary encoder **630.** A secondary encoder **651** is coupled to the tool to provide precise angular registration control of the patterned roll **662.** Primary **630** and secondary **651** encoders cooperate to provide control of the patterned roll **662** to keep it in registration with a second patterned roll, as will be described further hereinafter.

Reduction or elimination of shaft resonance is important as this is a source of registration error allowing pattern position control within the specified limits. Using a coupling **640** between the motor **633** and shaft **650** that is larger than general sizing schedules specify will also reduce shaft resonance caused by more flexible couplings. Bearing assemblies **660** are located in various locations to provide rotational support for the motor arrangement.

In the example embodiment shown, the tool roller **662** diameter can be smaller than its motor **633** diameter. To accommodate this arrangement, tool rollers may be installed in pairs arranged in mirror image. In **FIG. 7** two tool rollers assemblies **610** and **710** are installed as mirror images in order to be able to bring the two tool rollers **662** and **762** together. Referring also to **FIG.1****,** the first motor arrangement is typically fixedly attached to the frame and the second motor arrangement is positioned using movable optical quality linear slides.

Tool roller assembly **710** is quite similar to tool roller assembly **610,** and includes a motor **733** for driving a tool or patterned roll **762** is mounted to the machine frame **750** and connected through a coupling **740** to a rotating shaft **701** of the patterned roller **762.** The motor **733** is coupled to a primary encoder **730.** A secondary encoder **751** is coupled to the tool to provide precise angular registration control of the patterned roll **762.** Primary **730** and secondary **751** encoders cooperate to provide control of the patterned roll **762** to keep it in registration with a second patterned roll, as will be described further hereinafter.

Reduction or elimination of shaft resonance is important as this is a source of registration error allowing pattern position control within the specified limits. Using a coupling **740** between the motor **733** and shaft **750** that is larger than general sizing schedules specify will also reduce shaft resonance caused by more flexible couplings. Bearing assemblies **760** are located in various locations to provide rotational support for the motor arrangement.

Because the feature sizes on the microreplicated structures on both surfaces of a web are desired to be within fine registration of one another, the patterned rolls should be controlled with a high degree of precision. Cross-web registration within the limits described herein can be accomplished by applying the techniques used in controlling machine-direction registration, as described hereinafter. For example, to achieve about 10 micrometers end-to-end feature placement on a 10-inch circumference patterned roller, each roller must be maintained within a rotational accuracy of ± 32 arc-seconds per revolution. Control of registration becomes more difficult as the speed the web travels through the system is increased.

Applicants have built and demonstrated a system having 10-inch circular patterned rolls that can create a web having patterned features on opposite surfaces of the web that are registered to within 2.5 micrometers. Upon reading this disclosure and applying the principles taught herein, one of ordinary skill in the art will appreciate how to accomplish the degree of registration for other microreplicated surfaces.

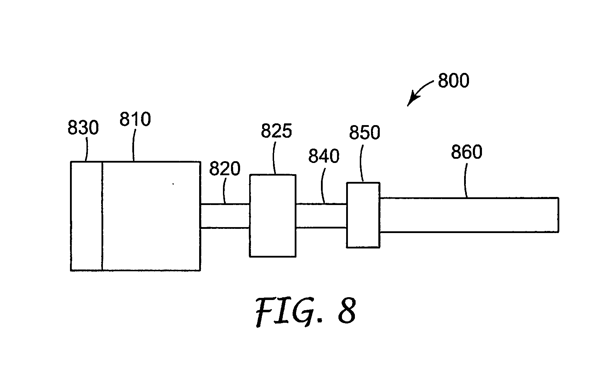

Referring to **FIG. 8****,** a schematic of a motor arrangement **800** is illustrated. Motor arrangement **800** includes a motor **810** including a primary encoder **830** and a drive shaft **820.** Drive shaft **820** is coupled to a driven shaft **840** of patterned roll **860** through a coupling **825.** A secondary, or load, encoder **850** is coupled to the driven shaft **840.** Using two encoders in the motor arrangement described allows the position of the patterned roll to be measured more accurately by locating the measuring device (encoder) **850** near the patterned roll **860,** thus reducing or eliminating effects of torque disturbances when the motor arrangement **800** is operating.

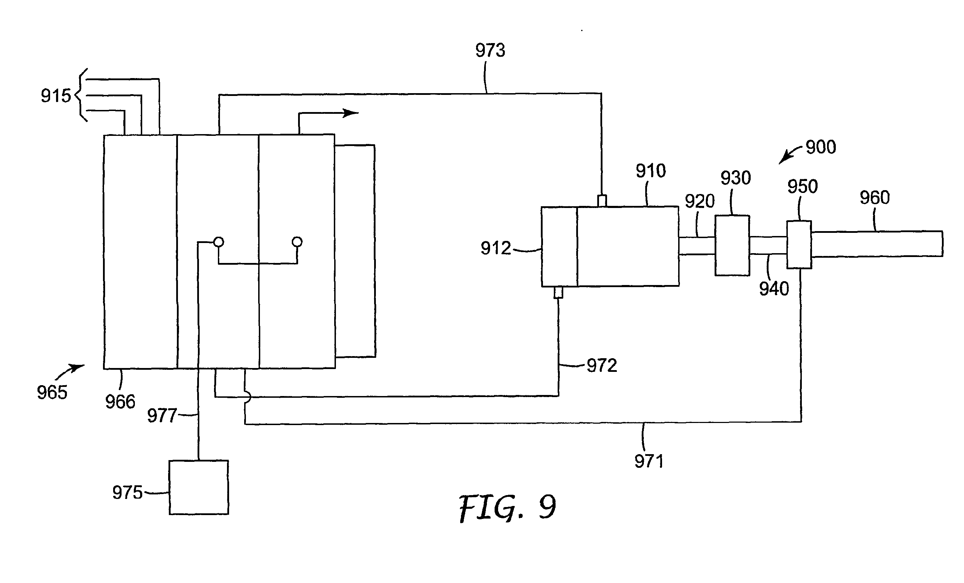

Referring to **FIG. 9****,** a schematic of the motor arrangement of **FIG. 8****,** is illustrated as attached to control components. In the example apparatus shown in **FIGS. 1-3****,** a similar set-up would control each motor arrangement **210** and **220.** Accordingly, motor arrangement **900** includes a motor **910** including a primary encoder **930** and a drive shaft **920.** Drive shaft **920** is coupled to a driven shaft **940** of patterned roll **960** through a coupling **930.** A secondary, or load, encoder **950** is coupled to the driven shaft **940.**

Motor arrangement **900** communicates with a control arrangement **965** to allow precision control of the patterned roll **960.** Control arrangement **965** includes a drive module 966 and a program module **975.** The program module **975** communicates with the drive module **966** via a line **977,** for example, a SERCOS fiber network. The program module **975** is used to input parameters, such as set points, to the drive module **966.** Drive module **966** receives input 480 volt, 3-phase power **915,** rectifies it to DC, and distributes it via a power connection **973** to control the motor **910.** Motor encoder **912** feeds a position signal to control module **966.** The secondary encoder **950** on the patterned roll **960** also feeds a position signal back to the drive module **966** via to line **971.** The drive module **966** uses the encoder signals to precisely position the patterned roll **960.** The control design to achieve the degree of registration is described in detail below.

In the illustrative embodiments shown, each patterned roll is controlled by a dedicated control arrangement. Dedicated control arrangements cooperate to control the registration between first and second patterned rolls. Each drive module communicates with and controls its respective motor assembly.

The control arrangement in the system built and demonstrated by Applicants include the following. To drive each of the patterned rolls, a high performance, low cogging torque motor with a high-resolution sine encoder feedback (512 sine cycles x 4096 drive interpolation >> 2 million parts per revolution) was used, model MHD090B-035-NGO-UN, available from Bosch-Rexroth (Indramat). Also the system included synchronous motors, model MHD090B-035-NG0-UN, available from Bosch-Rexroth (Indramat), but other types, such as induction motors could also be used.

Each motor was directly coupled (without gearbox or mechanical reduction) through an extremely stiff bellows coupling, model BK5-300, available from R/W Corporation. Alternate coupling designs could be used, but bellows style generally combines stiffness while providing high rotational accuracy. Each coupling was sized so that a substantially larger coupling was selected than what the typical manufacturers specifications would recommend.

Additionally, zero backlash collets or compressive style locking hubs between coupling.and shafts are preferred. Each roller shaft was attached to an encoder through a hollow shaft load side encoder, model RON255C, available from Heidenhain Corp., Schaumburg, IL. Encoder selection should have the highest accuracy and resolution possible, typically greater than 32 are-sec accuracy. Applicants' design, 18000 sine cycles per revolution were employed, which in conjunction with the 4096 bit resolution drive interpolation resulted in excess of 50 million parts per revolution resolution giving a resolution substantially higher than accuracy. The load side encoder had an accuracy of +/- 2 arc-sec; maximum deviation in the delivered units was less than +/- 1 arc-sec.

In some instances, each shaft may be designed to be as large a diameter as possible and as short as possible to maximize stiffness, resulting in the highest possible resonant frequency. Precision alignment of all rotational components is desired to ensure minimum registration error due to this source of registration error.

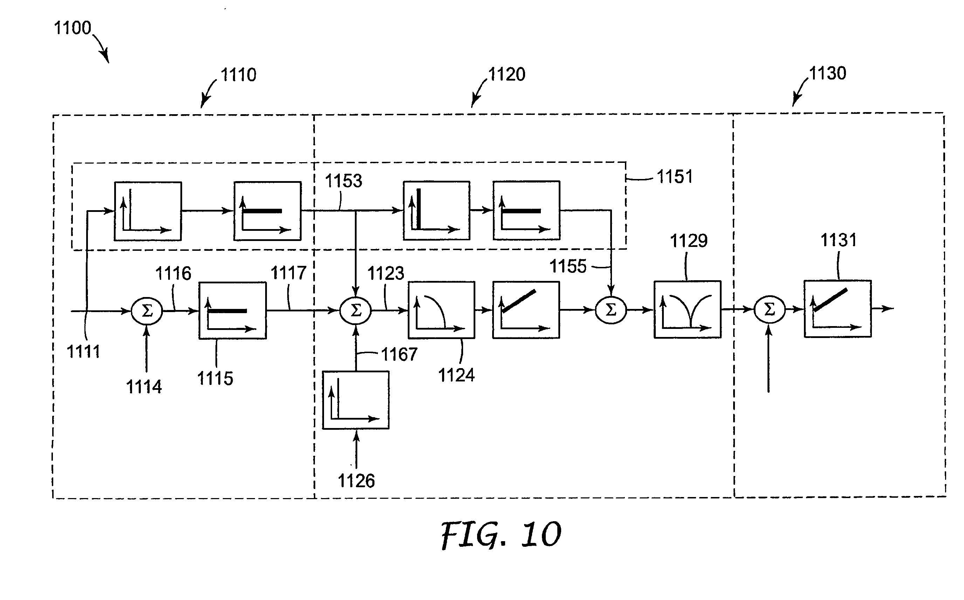

Referring to **FIG. 10****,** in Applicants' system identical position reference commands were presented to each axis simultaneously through a SERCOS fiber network at a 2 ms update rate. Each axis interpolates the position reference with a cubic spline, at the position loop update rate of 250 microsecond intervals. The interpolation method is not critical, as the constant velocity results in a simple constant times time interval path. The resolution is critical to eliminate any round off or numerical representation errors. Axis rollover must also addressed. In some cases, it is important that each axis' control cycle is synchronized at the current loop execution rate (62 microsecond intervals).

The top path **1151** is the feed forward section of control. The control strategy includes a position loop **1110,** a velocity loop **1120,** and a current loop **1130.** The position reference **1111** is differentiated, once to generate the velocity feed forward terms **1152** and a second time to generate the acceleration feed forward term **1155.** The feed forward path **1151** helps performance during line speed changes and dynamic correction.

The position command **1111** is subtracted from current position **1114,** generating an error signal **1116.** The error **1116** is applied to a proportional controller **1115,** generating the velocity command reference **1117.** The velocity feedback **1167** is subtracted from the command **1117** to generate the velocity error signal **1123,** which is then applied to a PID controller. The velocity feedback **1167** is generated by differentiating the motor encoder position signal **1126.** Due to differentiation and numerical resolution limits, a low pass Butterworth filter **1124** is applied to remove high frequency noise components from the error signal **1123.** A narrow stop band (notch) filter **1129** is applied at the center of the motor - roller resonant frequency. This allows substantially higher gains to be applied to the velocity controller **1120.** Increased resolution of the motor encoder also would improve performance. The exact location of the filters in the control diagram is not critical; either the forward or reverse path are acceptable, although tuning parameters are dependent on the location.

A PID controller could also be used in the position loop, but the additional phase lag of the integrator makes stabilization more difficult. The current loop is a traditional PI controller; gains are established by the motor parameters. The highest bandwidth current loop possible will allow optimum performance. Also, minimum torque ripple is desired.

Minimization of external disturbances is important to obtain maximum registration. This includes motor construction and current loop commutation as previously discussed, but minimizing mechanical disturbances is also important. Examples include extremely smooth tension control in entering and exiting web span, uniform bearing and seal drag, minimizing tension upsets from web peel off from the roller, uniform rubber nip roller. In the current design, a third axis geared to the tool rolls is provided as a pull roll to assist in removing the cured structure from the tool.

The web material can be any suitable material, as described above, on which a microreplicated patterned structure can be created. The web can also be multi-layered, as desired. Since the liquid is typically cured by a curing source on the side opposite that on which the patterned structure is created, the web material can be at least partially translucent to the curing source used. Examples of curing energy sources are infrared radiation, ultraviolet radiation, visible light radiation, microwave, or e-beam. One of ordinary skill in the art will appreciate that other curing sources can be used, and selection of a particular web material/curing source combination will depend on the particular article (having microreplicated structures in registration) to be created.

An alternative to curing the liquid through the web would be to use a two part reactive cure, for example, an epoxy, which would be useful for webs that are difficult to cure through, such as metal web or webs having a metallic layer. Curing could be accomplished by in-line mixing of components or spraying catalyst on a portion of the patterned roll, which would cure the liquid to form the microreplicated structure when the coating and catalyst come into contact.

The liquid from which the microreplicated structures are created can be a curable photopolymerizable material, such as acrylates curable by UV light. One of ordinary skill in the art will appreciate that other coating materials can be used, and selection of a material will depend on the particular characteristics desired for the microreplicated structures. Similarly, the particular curing method employed is within the skill and knowledge of one of ordinary skill in the art. Examples of curing methods are reactive curing, thermal curing, or radiation curing.

Examples of coating means that useful for delivering and controlling liquid to the web are, for example, die or knife coating, coupled with any suitable pump such as a syringe or peristaltic pump. One of ordinary skill in the art will appreciate that other coating means can be used, and selection of a particular means will depend on the particular characteristics of the liquid to be delivered to the web.

## Claims

1. A roll to roll microreplication apparatus comprising:
a first patterned roll (460) having a first diameter;
a second patterned roll (474) having a second diameter; and
a drive assembly configured to rotate the first patterned roll (460) and the second patterned roll (474) such that the first and second rolls maintain a continuous registration within 100 micrometers;
wherein the second diameter is 0.01 to 1 percent larger than the first diameter.

2. The roll to roll microreplication apparatus of claim 1, wherein the first patterned roll (460) and the second patterned roll (474) maintain a continuous registration within 10 micrometers.

3. The roll to roll microreplication apparatus of claims 1 or 2, further comprising a first coating head (456) disposed adjacent the first patterned roll (460) and a second coating head (464) disposed adjacent the second patterned roll (474).

4. The roll to roll microreplication apparatus of claims 1,2 or 3, further comprising a first curing source (525) disposed adjacent the first patterned roll (460) and a second curing source (535) disposed adjacent the second patterned roll (474).

5. A method of making a microreplicated article including a web (422) having first and second opposed surfaces, the method comprising:
counter-rotating a first patterned roll (460) and a second patterned roll (474) at an equal rotational speed but a non-equal surface speed;
passing the web (422) between the first patterned roll (460) and the second patterned roll (474);
disposing a first liquid (470) on the web first surface;
contacting the first liquid (470) with the first patterned roll (460);
disposing a second liquid (481) on the web second surface; and
contacting the second liquid (481) with the second patterned roll (474);
wherein the first and second rolls maintain a constant registration of less than 100 micrometers.

6. The method of claim 5, further comprising a step of curing the first liquid (470) to create a first microreplicated pattern prior to disposing a second liquid (481) on the web (422) second surface.

7. The method of claim 6, wherein the step of contacting the second liquid (481) occurs while the first microreplicated pattern is in contact with the first patterned roll (460).

8. The method of claim 5, further comprising a step of curing the second liquid (481) to create a second microreplicated pattern.

## Patentansprüche

1. Walze-zu-Walze-Mikroreplikationsvorrichtung, aufweisend:
eine erste profilierte Walze (460) mit einem ersten Durchmesser;
eine zweite profilierte Walze (474) mit einem zweiten Durchmesser; und
eine Antriebsanordnung, die zum Drehen der ersten profilierten Walze (460) und der zweiten profilierten Walze (474) derart konfiguriert ist, dass die erste und zweite Walze eine kontinuierliche Registrierung innerhalb von 100 Mikrometern beibehalten;
wobei der zweite Durchmesser 0,01 bis 1 Prozent größer als der erste Durchmesser ist.

2. Walze-zu-Walze-Mikroreplikationsvorrichtung nach Anspruch 1, wobei die erste profilierte Walze (460) und die zweite profilierte Walze (474) eine kontinuierliche Registrierung innerhalb von 10 Mikrometern beibehalten.

3. Walze-zu-Walze-Mikroreplikationsvorrichtung nach Anspruch 1 oder 2, ferner aufweisend einen ersten Beschichtungskopf (456) neben der ersten profilierten Walze (460) und einen zweiten Beschichtungskopf (464) neben der zweiten profilierten Walze (474).

4. Walze-zu-Walze-Mikroreplikationsvorrichtung nach Anspruch 1, 2 oder 3, ferner aufweisend eine erste Aushärtungsquelle (525) neben der ersten profilierten Walze (460) und einer zweiten Aushärtungsquelle (535) neben der zweiten profilierten Walze (474).

5. Verfahren zur Herstellung eines mikroreplizierten Gegenstands, aufweisend eine Bahn (422) mit einer ersten und zweiten Fläche, die einander gegenüberliegen, wobei das Verfahren Folgendes aufweist:
Entgegendrehen einer ersten profilierten Walze (460) und einer zweiten profilierten Walze (474) mit einer gleichen Drehgeschwindigkeit, aber einer ungleichen Oberflächengeschwindigkeit;
Führen der Bahn (422) zwischen der ersten profilierten Walze (460) und der zweiten profilierten Walze (474);
Vorsehen einer ersten Flüssigkeit (470) auf der ersten Fläche der Bahn;
Inkontaktbringen der ersten Flüssigkeit (470) mit der ersten profilierten Walze (460);
Vorsehen einer zweiten Flüssigkeit (481) auf der zweiten Fläche der Bahn; und
Inkontaktbringen der zweiten Flüssigkeit (481) mit der zweiten profilierten Walze (474);
wobei die erste und zweite Walze eine konstante Registrierung innerhalb von weniger als 100 Mikrometer beibehalten.

6. Verfahren nach Anspruch 5, ferner umfassend einen Schritt des Aushärtens der ersten Flüssigkeit (470) zur Schaffung eines ersten mikroreplizierten Musters vor dem Schrittes Vorsehens einer zweiten Flüssigkeit (481) auf der zweiten Fläche der Bahn (422).

7. Verfahren nach Anspruch 6, wobei der Schritt des Inkontaktbringens der zweiten Flüssigkeit (481) stattfindet, während das erste mikroreplizierte Muster mit der ersten profilierten Walze (460) in Kontakt ist.

8. Verfahren nach Anspruch 5, ferner umfassend einen Schritt des Aushärtens der zweiten Flüssigkeit (481) zur Schaffung eines zweiten mikroreplizierten Musters.

## Revendications

1. Appareil de microreproduction de rouleau à rouleau comprenant :
- un premier rouleau (460) à motif qui présente un premier diamètre,
- un deuxième rouleau (474) à motif qui présente un deuxième diamètre et
- un ensemble d'entraînement configuré pour faire tourner le premier rouleau (460) à motif et le deuxième rouleau (474) à motif de manière à maintenir entre le premier rouleau et le deuxième rouleau à motif un cadrage constant à 100 micromètres près, le deuxième diamètre étant plus grand que le premier diamètre d'un pourcentage compris entre 0,01 et 1 pour cent.

2. Appareil de microreproduction de rouleau à rouleau selon la revendication 1, dans lequel le premier rouleau (460) à motif et le deuxième rouleau (474) à motif maintiennent un cadrage constant à 10 micromètres près.

3. Appareil de microreproduction de rouleau à rouleau selon les revendications 1 ou 2, comprenant de plus une première tête d'enduction (456) placée à côté du premier rouleau (460) à motif et une deuxième tête d'enduction (464) placée à côté du deuxième rouleau (474) à motif.

4. Appareil de microreproduction de rouleau à rouleau selon les revendications 1, 2 ou 3, comprenant de plus une première source de durcissement (525) placée à côté du premier rouleau (460) à motif et une deuxième source de durcissement (535) placée à côté du deuxième rouleau (474) à motif.

5. Procédé de fabrication d'un objet par microreproduction, comprenant une nappe (422) qui présente une première surface et une deuxième surface opposées l'une à l'autre, le procédé comprenant les étapes qui consistent à :
- faire tourner en sens opposés un premier rouleau (460) à motif et un deuxième rouleau (474) à motif à des vitesses de rotation égales mais à des vitesses de surface qui ne sont pas égales,
- faire passer la nappe (422) entre le premier rouleau (460) à motif et le deuxième rouleau (474) à motif,
- placer un premier liquide (470) sur la première surface de la nappe,
- mettre le premier liquide (470) en contact avec le premier rouleau (460) à motif,
- placer un deuxième liquide (481) sur la deuxième surface de la nappe et
- mettre le deuxième liquide (481) en contact avec le deuxième rouleau (474) à motif,
- le premier rouleau et le deuxième rouleau présentant un cadrage constant à moins de 100 micromètres près.

6. Procédé selon la revendication 5, comprenant de plus l'étape qui consiste à durcir le premier liquide (470) pour obtenir un premier motif microreproduit avant de déposer un deuxième liquide (481) sur la deuxième surface de la nappe (422).

7. Procédé selon la revendication 6, dans lequel l'étape qui consiste à mettre en contact le deuxième liquide (481) a lieu lorsque le premier motif microreproduit est en contact avec le premier rouleau (460) à motif.

8. Procédé selon la revendication 5, comprenant de plus une étape qui consiste à durcir le deuxième liquide (481) pour obtenir un deuxième motif microreproduit.
